# EUROPEAN PATENT APPLICATION

(11) **EP 4 422 368 A2**
(43) Date of publication of application: **28.08.2024**
(21) Application number: 24159066.0
(22) Date of filing: 22.02.2024
(51) Int. Cl.: H05K 7/20

(54) **ZERO-U COOLANT DISTRIBUTION UNIT**

(30) Priority: 22.02.2023 US 202363486346 P
(71) Applicant: Vertiv Corporation, Westerville, OH 43082 (US)
(72) Inventor: Grantham, Roy L., O'Fallon (US)
(74) Representative: Cousens, Nico

(57) **Abstract**

The present disclosure is directed to a server rack assembly, per an embodiment. The server rack includes a housing and a coolant distribution unit. The housing includes a front space region, a rear space region, a plurality of side walls, and at least one rack for supporting heat-generating electronic devices. The coolant distribution unit is located within the rear space region of the housing, proximate to at least one of the plurality of side walls.

## Description

### BACKGROUND

The present invention relates to computer hardware cabinets, and more particularly, this invention relates to the placement of a cooling apparatus within a computer hardware cabinet.

As demands for computing power continue to grow, so too do the demands for energy and cost-efficient cooling methods. This need is particularly critical in computer cabinet systems, where many rack mounted computing systems are arranged in a high-density environment, resulting in large amounts of heat which can limit the viability of air cooling. Previous solutions for these cabinets can include an array of fans moving excess heat out of the cabinet into the room the cabinet is located in, in combination with computer-room air conditioners that then cool the warm air. In order to address the need for cooling high-density environments, there exist liquid cooling solutions. These cooling solutions include coolant distribution units (CDU) which coordinate the flow and distribution of liquid coolant throughout the computing systems. One example of such a CDU is the LIEBERT XDU Coolant Distribution Unit manufactured by applicant. However, such a CDU can take up valuable floor space that can otherwise be occupied by additional computing systems. The need for taking up less floor space can be addressed by rack-mounted CDUs that are rack mounted in the same rack as the computing systems. Typically, a rack-mounted CDU is mounted at the top or bottom of the rack within a computing cabinet. While rack-mounting a CDU does provide benefits such as reducing the floor footprint of cooling equipment, rack-mounted CDUs still occupy valuable server rack space.

If a user decides to utilize a rack-based CDU, it can minimize the CDU's footprint within the computer cabinet and data center, but at the expense of other components that can occupy more space within a standard rack including infrastructure such as a network switch or UPS or additional computing systems. As a result, utilizing a rack-based CDU can significantly limit the total number of devices that can exist in a standard rack. Therefore, there exists a need for a small footprint CDU that does not restrict the space where other computing devices can be mounted.

### DRAWINGS

The detailed description is described with reference to the accompanying figures.
FIG. 1A illustrates a front orthogonal view of an enclosed server rack cabinet;
FIG. 1B illustrates a rear view of an open server cabinet including a rack and a rear mounted coolant distribution unit;
FIG. 2A illustrates an orthogonal view of a vertical oriented coolant distribution unit;
FIG. 2B illustrates a sectional view of a vertical oriented coolant distribution unit and the internal components therein; and
FIG. 3 illustrates a schematic diagram of a cooling system in a data center.

### SUMMARY

This section provides a general summary of the disclosure and is not a comprehensive disclosure of its full scope or all of its features.

In an embodiment, the present disclosure is directed towards a server rack assembly. The server rack assembly includes a housing, with at least one rack configured to support heat-generating devices, a front space region, a rear space region, and a plurality of side walls. The server rack assembly further includes a coolant distribution unit located proximate to the rear space region and one of the plurality of side walls.

In an embodiment, the coolant distribution unit includes a housing, a control valve, a first active pump, a second redundant pump, an external liquid inlet and an external liquid outlet for receiving and returning coolant liquid from outside the coolant distribution unit, an external liquid outlet to supply coolant to the computing systems, an external liquid inlet to receive warm coolant from the computing systems, a heat exchanger, an expansion tank within the housing, and electronic control logic for controlling the operation of the coolant distribution unit.

In an embodiment, the present disclosure is also directed towards a server rack assembly. The server rack assembly contains a housing with at least one rack configured to support heat generating devices, a front space region, a rear space region, and a plurality a side walls. The server rack assembly also contains a coolant distribution unit located proximate the rear space region and one of the plurality of side walls. There also exists a manifold connected to the coolant distribution unit and a plurality of connection points between the manifold and the heat-generating electronic devices.

### DETAILED DESCRIPTION

Aspects of the disclosure are described more fully hereinafter with reference to the accompanying drawings, which form a part hereof, and which show, by way of illustration, example features. The features can, however, be embodied in many different forms and should not be construed as limited to the combinations set forth herein; rather, these combinations are provided so that this disclosure will be thorough and complete and will fully convey the scope. The following detailed description is, therefore, not to be taken in a limiting sense.

The present disclosure offers a space saving solution for coolant distribution units (CDU) that are housed within data center cabinets. In addition to electronic computing devices mounted on a rack within a cabinet, a CDU can also be mounted on a rack within a cabinet to provide liquid cooling functionality to the electronic computing devices. The space that a rack mounted electronic device occupies on a rack is measured in standard units of 1.75 inches (approximately 4.445 cm), often referred to as a "rack unit" or a "u space." When an electronic device is mounted in a location not on the rack, it is considered to be "zero u" since it takes up no space within the internal rack housing. The present invention allows for a CDU to be mounted behind a rack in the rear space of a cabinet, whereas it can be considered a "zero u" CDU.

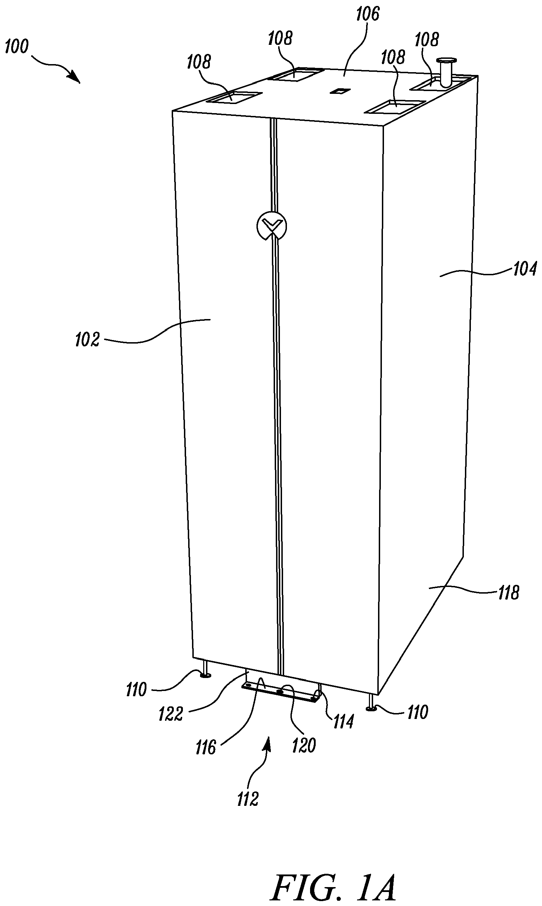

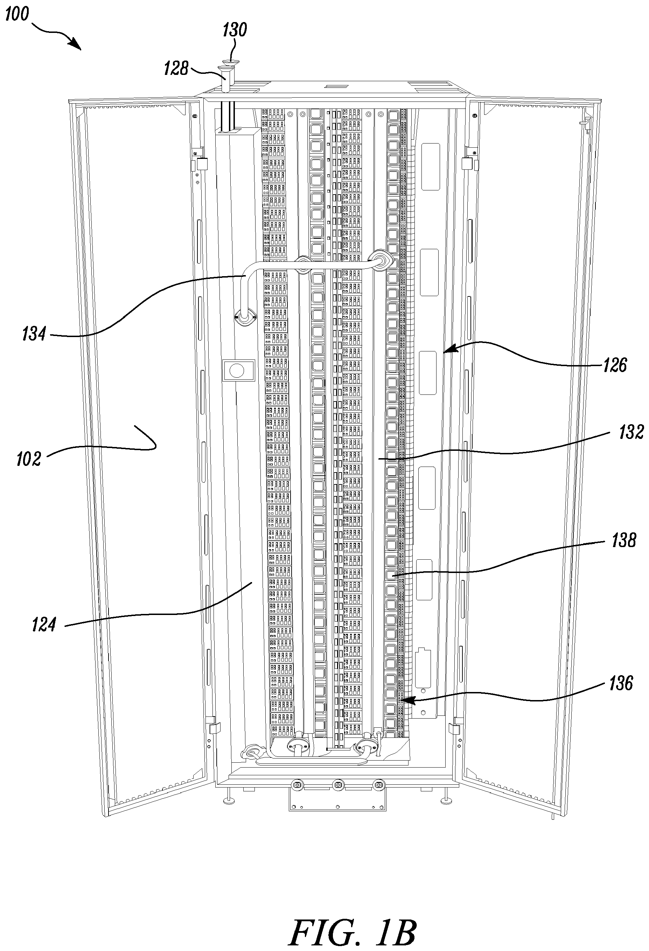

Shown throughout the figures, the present disclosure is directed towards a computer cabinet that utilizes a "zero u" CDU. Referring initially to FIGS. 1A, and 1B, a computer cabinet 100 is illustrated in accordance with an exemplary embodiment of the present disclosure.

FIG. 1A is a front orthogonal view illustrating a computer cabinet 100 according to one embodiment of the present invention. The computer cabinet 100 includes a front door 102 in a closed position, at least one side panel 104, and a top panel 106. The computer cabinet 100 also includes top openings 108 included in the top panel 106 that can accommodate input and exhaust features of internal cabinet components. For example, chilled water, refrigerant, or other types of heat-carrying fluids can be supplied to components in the interior of the computer cabinet 100. As depicted, the bottom of computer cabinet 100 includes risers 110 to separate the computer cabinet 100 from the ground and ensure that there is no inadvertent movement of the computer cabinet 100. The risers 110 can be located at the four corners of the computer cabinet 100 as depicted. The computer cabinet 100 further includes a stabilizing plate 112 that provides for the computer cabinet 100 to be securely fastened to the floor. For example, the stabilizing plate 112 can improve stability by anchoring the computer cabinet 100 to a fixed point on the floor surface. Certain regulatory requirements can require the use of a stabilizing plate 112 that prevents tipping over in response to unwanted forces, such as seismic force, inadvertent contact by a person, or forces applied when making changes within the computer cabinet 100. The stabilizing plate 112 includes a horizontal base plate 114 and a vertical plate 116 attached to the base 118 of the computer cabinet 100. The horizontal base 114 includes a number of floor mounting holes 120. The vertical plate 116 includes a number of cabinet mounting holes 122. The floor mounting holes 120 can facilitate the use of fasteners to affix the computer cabinet 100 to a fixed point such as the ground or a structure fixed to the ground.

FIG. 1B is a rear view illustrating the computer cabinet 100 with rear doors 123 in an open position revealing the interior of the computer cabinet 100. Further depicted is a coolant distribution unit (CDU) 124 located within the interior of the computer cabinet 100. In the present embodiment, the coolant distribution unit 124 is located in the rear space 126 of the computer cabinet 100, close to the rear doors 123. The coolant distribution unit 124 can include an input conduit 128 and an exhaust conduit 130. In an embodiment, the input conduit 128 and exhaust conduit 130 can extend from the interior to the exterior of the computer cabinet 100 via a top opening 108. The conduits 128, 130 can respectively supply chilled water to the CDU 124 and carry away warmed water from the CDU 124. In other embodiments, other refrigerants can be respectively supplied and carried away from the CDU 124, including water/glycol, or any compatible sensible phase liquid.

FIG. 1B also illustrates a manifold 132 that extends down the vertical length of the computer cabinet 100. In an embodiment, the manifold 132 can carry coolant to and from the coolant distribution unit 124 to cool systems within the computer cabinet 100. The coolant distribution unit 124 can be connected to the manifold 132 via a tubing 134. In an embodiment, the tubing 134 can be a rigid pipe; while in another embodiment the tubing 134 can be a flexible hose. There further exists an array of couplings down the vertical length of the manifold 132 by which the electronic equipment within the computer cabinet 100 can be fluidly coupled with the coolant distribution unit 124.

Further, FIG. 1B illustrates a server rack 136 that is housed on the interior of the computer cabinet 100. The server rack 136 is capable of securely holding rack mountable systems 138. In embodiments, the rack mountable system 138 can, by way of example, be a server blade, a power supply unit, a keyboard, video, and mouse (KVM) switch, or a network patch panel. In addition, the rack mountable systems 138 can be secured to the server rack 136 in a repeatable fashion that can present components also in a known, repeatable fashion. For example, the rack mountable system 138 can include a coupling extending from the rear portion that is presented in a known, repeatable fashion by virtue of the method of mounting the rack mountable system 138 to the server rack 136. In this way, the rack mountable system 138 can be connected to the manifold 132 via a coupling to allow coolant distributed from the coolant distribution unit 124 to cool the rack mountable system 138. In addition, the rack mountable system 138 can include networking and power cables extending from the rear in a known, repeatable fashion, allowing for simpler and safer cable replacement or repair.

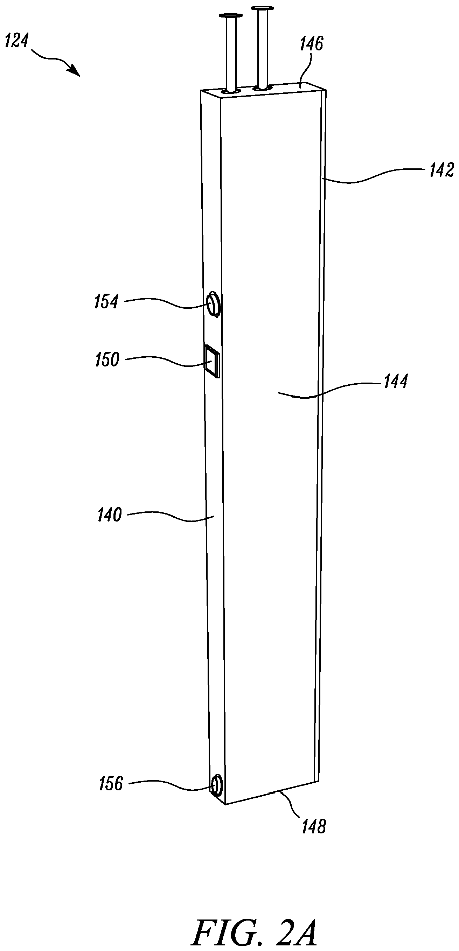

FIG. 2A illustrates a coolant distribution unit 124. The coolant distribution unit includes a front panel 140, a rear panel 142, side panels 144, a top panel 146, and a bottom panel 148 that cooperate to define a housing for CDU 124. The panels 140, 142, 144, 146, and 148 can be constructed with a sheet metal or composite material. The CDU 124 further includes an input conduit 128, and an exhaust conduit 130. As depicted the conduits 128, 130 connect the interior of CDU 124 to the exterior through top panel 146. In an embodiment, the vertical distance from the top panel 146 to the bottom panel 148 is greater than the horizontal distance from the front panel 140 to the rear panel 142.

As shown in FIG. 2A, in an exemplary embodiment, the CDU 124 includes a human machine interface (HMI) 150 located on the front panel 140. The HMI can be connected to the electronic control system of the CDU 124. The HMI 150 is capable of allowing user input to control CDU 124 features such as changing coolant flow rates, coolant flow pressures, or turning the CDU 124 on and off. Further, the HMI is capable of displaying critical information related to the operation of the CDU, such as warnings, alarms, and temperature information of the coolant and the electronic systems within the computer cabinet 100. However, it is to be understood that the HMI can be configured to display any information captured by CDU 124 during its operation. The HMI 150 can also be a logo plate. It is further contemplated that the CDU 124 can include both an HMI and logo plate in the same location on the computer cabinet 100.

FIG. 2A further shows an upper manifold connection point 152 and a lower manifold connection point 154. The upper manifold connection point 152 can be positioned on the front panel 140 proximal to the top panel 146 of the CDU 124. The lower manifold connection point 154 can be positioned on the front panel 140 proximal to the bottom panel 148 of the CDU 124. In an embodiment, the tubing 134 can be connected to the CDU 124 at the upper manifold connection point 152 and connected to the rack. The tubing 134 is configured to carry cooled coolant from the CDU 124 to the rack manifold in order to absorb the heat produced by the electronic systems therein. In an exemplary embodiment, the electronic systems therein can include a uniform coupling extending from the rear portion, allowing for a consistent attachment point to the rack manifold. Further, a tubing can be connected to the rack manifold and the lower manifold connection point 154. This tubing is configured to carry warmed coolant from the rack manifold to the CDU 124. It is to be understood, however, that the tubing 134 used to carry coolant from the CDU 124 to the rack and from the rack to the CDU 124 can be a flexible hose or a rigid pipe. A rigid hose or pipe can make it easier for a user to effectively organize cables extending from the rear of the computer cabinet 100. It is also to be understood that the length of the fixed hose or flexible hose can be any length required to comfortably connect the CDU 124 to the computer cabinet 100.

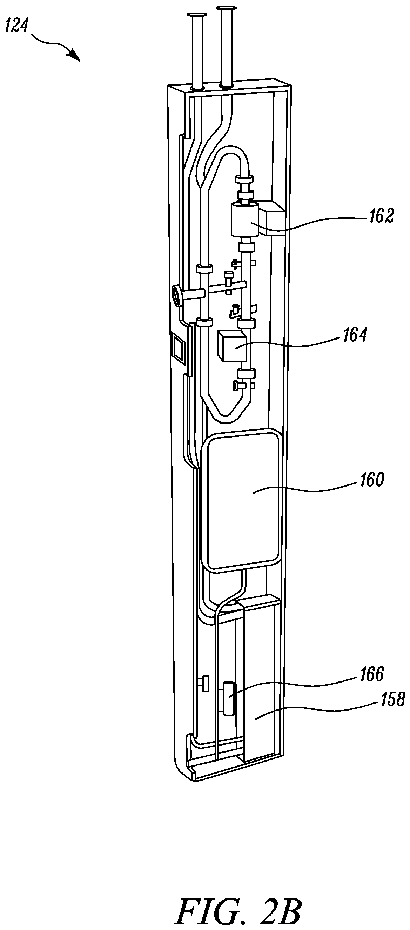

FIG. 2B illustrates an interior view of a coolant distribution unit 124. The coolant distribution unit 124 can consist of a heat exchanger 156, an expansion tank 158, an upper pump 160, a lower pump, for redundancy 162, and a control valve 164. In an embodiment, the heat exchanger 156 is a brazed plate heat exchanger. It is to be understood, however, that the heat exchanger 156 can be any type of plate exchanger. The heat exchanger 156 can be located proximate to the rear panel 142 and bottom panel 148 of the coolant distribution unit 124. The input conduit 128 receives coolant from an external source and passes the coolant through the coolant distribution unit 124 until the coolant exits via a flexible tube to the manifold 132. The exhaust conduit 130 takes used coolant from the manifold 132 that passes through the heat exchanger 156 to a location outside of the coolant distribution unit 124 to be recycled and used again as coolant, once the heat has been removed from the coolant.

FIG. 2B further illustrates the relative position of the interior components of the coolant distribution unit 124. Previously, the packaging and desired use cases of rack mounted CDUs necessitated a horizonal orientation of internal components, such that CDUs are sized and dimensioned to be mountable within standard server rack space. It can be contemplated, that, due to the vertical orientation of the CDU 124, the relative position of the interior components can contribute to and increase the operational efficiency of the CDU. In an exemplary embodiment, the heat exchanger 156 is located below all other major components. Since the coolant moves down the rack within the computer cabinet 100, the coolant eventually reenters the CDU 124 at the bottom of the cabinet via connection 154. The cold facility side water flow is controlled by valve 164, thereby regulating the heat exchange in order to achieve the desired temperature change. Accordingly, the heat exchanger is positioned within the bottom of the CDU 124. Further, the expansion tank 158 is located proximately above the heat exchanger 156. The expansion tank 158 is connected to the warm return piping from the manifold and prevents excessive water pressure by handling the thermal expansion of water. The upper pump 160 and lower redundant pump 162 are located above the expansion tank 158 and proximate to the manifold supply connection point 152. The outlet of the pumps 160, 162 are connected to connection point 152 and are configured to modify the flow rate in response to temperature fluctuations of the coolant or user input from the HMI 150. The pump operation flows out to the rack manifold via connection 152.

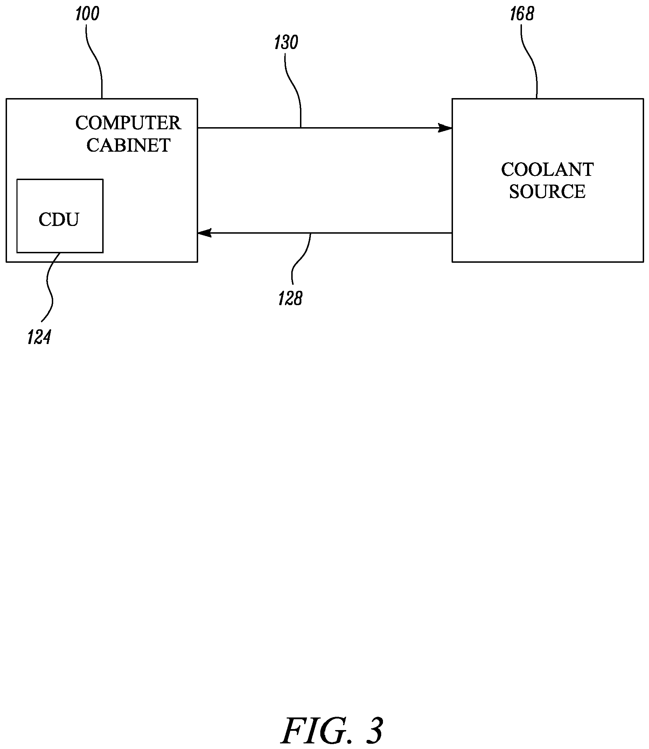

FIG. 3 shows a schematic diagram of a data center that utilizes a zero-u coolant distribution 124. The coolant distribution unit 124 is mounted within the rear space 126 of the computer cabinet 100. A coolant source 166 can be located within the data center facility or outside of the data center facility. The coolant source 166 can be a cold water tank, a computer room air conditioning unit (CRAC), or a geothermal source. The coolant distribution unit 124 receives coolant from the coolant source 166 via the input conduit 128. The received coolant is then distributed by the coolant distribution unit 124 to electronic systems mounted in the computer cabinet 100. Once the rack mountable systems 138 within the computer cabinet 100 are cooled, the CDU 124 sends the coolant, via the exhaust conduit 130, back to the coolant source 166 where it can be recycled for use again, once the heat has been sufficiently removed from the coolant.

Also disclosed are the following numbered clauses:
1. A server rack assembly (100) comprising:
   a housing comprising:
      at least one rack (136) configured to support heat-generating electronic devices,
      a front space region,
      a rear space region (126), and
      a plurality of side walls (104);
   a coolant distribution unit (124) located proximate the rear space region and
   one of the plurality of side walls,
   a manifold (132) connected to the coolant distribution unit, and
   a plurality of connection points between the manifold and the heat-generating electronic devices.
2. The server rack assembly of clause 1, wherein the manifold is vertically oriented along one of the side walls to distribute a coolant to the heat-generating electronic devices.
3. The server rack assembly of clause 2, wherein the connection points include a quick-disconnect coupling for easy maintenance and reconfiguration of electronic devices.
4. The server rack assembly of any of clauses 1 to 3, wherein the coolant distribution unit and the manifold are integrated into a single module.
5. The server rack assembly of any of clauses 1 to 4, wherein the manifold further comprises a plurality of sensors to monitor a flow rate and a temperature at a plurality of locations in the server rack to optimize cooling performance.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. A server rack assembly (100) comprising:
a housing comprising:
at least one rack (136) configured to support heat-generating electronic devices,
a front space region,
a rear space region (126),
a plurality of side walls (104); and
a coolant distribution unit (124) located proximate the rear space region and one of the plurality of side walls.

2. The server rack assembly of claim 1, wherein the coolant distribution unit comprises:
a housing (140, 142, 144, 146, 148),
a coolant distribution loop disposed in said housing and comprising:
a first pump (160),
a second pump (162),
a control valve (164),
an external liquid inlet (128) for receiving a returning, coolant liquid from outside the coolant distribution unit,
an external liquid outlet (130) for providing coolant liquid from inside the coolant distribution unit, and
a heat exchanger (156),
an expansion tank (158) within the housing; and
electronic control logic.

3. The server rack assembly of claim 2, wherein the heat exchanger is a brazed plate heat exchanger.

4. The server rack assembly of claim 2 or 3, wherein the electronic control logic is configured to automatically adjust coolant flow based on temperature readings of the electronic devices.

5. The server rack assembly of any of claims 2 to 4, wherein the first pump and the second pump operate in a primary-redundant configuration to ensure uninterrupted cooling.

6. The server rack assembly of any of claims 2 to 5, further comprising a user interface (150) on the coolant distribution unit for manual control and monitoring of cooling parameters.

7. The server rack assembly of any preceding claim, further comprising a stabilizing feature (112) for securing the rack assembly to a floor to prevent tipping under load.

8. The server rack assembly of any preceding claim, wherein the rear space region is configured to allow an inflow and outflow of coolant to the coolant distribution unit.

9. The server rack assembly of any preceding claim, wherein the housing is constructed of a thermal insulating material to enhance cooling efficiency and reduce energy consumption.

10. The server rack assembly of any preceding claim, further comprising:
a manifold (132) connected to the coolant distribution unit, and
a plurality of connection points (134) between the manifold and the heat-generating electronic devices.

11. The server rack assembly of claim 10, wherein the manifold is vertically oriented along one of the side walls to distribute a coolant to the heat-generating electronic devices.

12. The server rack assembly of claim 11, wherein the connection points include a quick-disconnect coupling for easy maintenance and reconfiguration of electronic devices.

13. The server rack assembly of any of claims 10 to 12, wherein the coolant distribution unit and the manifold are integrated into a single module.

14. The server rack assembly of any of claims 10 to 13, wherein the manifold further comprises a plurality of sensors to monitor a flow rate and a temperature at a plurality of locations in the server rack to optimize cooling performance.

15. A data center cooling system comprising:
a housing comprising:
at least one rack (136) configured to support heat-generating electronic devices,
a front space region,
a rear space region,
a plurality of side walls (104);
a cooling fluid source (166);
a coolant distribution unit (124) connected to the cooling fluid source;
wherein the coolant distribution unit is mounted within the rear space region of the cabinet.
